# EUROPEAN PATENT APPLICATION

(11) **EP 2 779 238 A1**
(43) Date of publication of application: **17.09.2014**
(21) Application number: 13196750.7
(22) Date of filing: 11.12.2013
(51) Int. Cl.: H01L 25/075, H01L 33/62, H01L 33/64

(54) **Luminous element, bar-type luminous element and applications thereof**

(30) Priority: 15.03.2013 TW 102109265
(71) Applicant: Lextar Electronics Corp., 30075 Hsinchu (TW)
(72) Inventor: Yang, Kuang-Neng, 310 Hsinchu County (TW); Wu, Kun-Hua, 302 Hsinchu County (TW); Chen, Jo-Hsiang, 231 New Taipei City (TW); Lin, Chih-Hao, 10672 Taipei City (TW); Hsu, Che-Wei, Taipei City (TW); Tsai, Tzong-Liang, 407 Taichung City (TW)
(74) Representative: Granleese, Rhian Jane

(57) **Abstract**

A luminous element includes a heat dissipation plate, a body, a plurality of LED chips, a first connector and a second connectors. The heat dissipation plate includes a die-bonding area and a heat dissipation area opposite to the die-bonding area. The body surrounds the heat dissipation plate, and includes a first body surface and a second body surface opposite to the first body surface. The first body surface includes a concave part exposing the die-bonding area. The second body surface includes an opening exposing the heat dissipation area. The LED chips are mounted on the die-bonding area. The first and the second connectors are disposed on the body, and they can be pluggably connected to an external power source or other connectors. The LED chips are connected to the electrical input terminals in the first and the second connectors.

## Description

### BACKGROUND

### Technical Field

Embodiments of the present invention relate to a luminous element. More particularly, embodiments of the present invention relate to a luminous element, a bar-shaped luminous element and the applications thereof.

### Description of Related Art

In an LED lighting device such as a lamp or a backlight module in the display, plural LED chips are encapsulated in a lighting unit disposed on a substrate of the lamp or the backlight module. By wire soldering, the LED chips of the lighting unit are soldered to a circuit board in the lamp or the backlight module, so as to be electrically connected to the components, e.g. the driving module, on the circuit board.

However, if the LED chip is damaged and needs to be replaced, the soldering wires have to be desoldered to remove the damaged lighting unit and place a new lighting unit on the substrate. Afterwards, the new lighting unit needs to be wire- soldered to the circuit board. Therefore, it is inconvenient for the existing lamp or the backlight module to maintain or replace the lighting unit.

### SUMMARY

A summary of various embodiments according to the present invention are disclosed below. It should be understood that these aspects are presented merely to provide the reader with a brief summary of these certain embodiments and that these aspects are not intended to limit the scope of this disclosure.

Embodiments of the present invention provide a luminous element, bar-shaped luminous element that are easily to be replaced, so as to overcome the difficulty in the prior art.

In one aspect of the present invention, a luminous element includes a heat dissipation plate, a body, a plurality of LED chips, a first connector, a second connector, a first circuit and a second circuit. The heat dissipation plate includes a first surface and a second surface. The first surface has a die bonding area, and the second surface has a heat dissipation area. The body surrounds the heat dissipation plate, and includes a first body surface and a second body surface opposite to the first body surface. The first body surface includes a concave part exposing the die bonding area. The second body surface includes an opening exposing the heat dissipation area. The LED chips are mounted on the die bonding area. The first and second connectors are respectively disposed on the edge of the first body surface or the edge of the second body surface of the body. The first and the second connectors both include a first and a second electrical input ports for being pluggably connected to an external power source or other connectors. The first circuit and the second circuit are disposed in the body. The LED chips are electrically connected between the first and the second circuits. The first circuit is electrically connected to the first electrical input ports of the first and the second connectors, and the second circuit is electrically connected to the second electrical input ports of the first and the second connectors.

The foregoing luminous element can be connected to or disconnected from the external power source or other connectors via the first connector and the second connector, so as to facilitate to replace the luminous element.

In another aspect of the present invention, a direct type backlight module includes a backlight source, a diffusion plate and a housing. The backlight source includes a plurality of luminous elements as described above. The first connector and/or the second connector of one of the luminous elements are pluggably connected to the first connector and/or the second connector of an adjacent one of the luminous elements via a connection wire connection wire having two third connectors at opposite ends thereof, so that the luminous elements are connected in series to form the backlight source. The diffusion plate is disposed above the backlight source. The housing accommodates the backlight source and the diffusion plate for constructing the direct type backlight module. The heat dissipation area of each of the luminous elements is in contact with the housing.

In the foregoing direct type backlight module, any luminous element can be connected to or disconnected from other luminous elements via the connection wireconnection wire, so as to replace the luminous element.

In another aspect of the present invention, an edge-lit type backlight module includes a light guide plate, a light bar and a housing. The light guide plate has a light outgoing surface and a light incident surface perpendicular to the light outgoing surface. The light bar faces toward the light incident surface, such that the light bar emits a light toward the light incident surface. The light bar includes a plurality of luminous elements as described above. The first connector and/or the second connector of one of the luminous elements are pluggably connected to the first connector and/or the second connector of an adjacent one of the luminous elements via a connection wire having two third connectors at opposite ends thereof, so that the luminous elements are connected in series. The housing accommodates the light bar and the light guide plate for constructing the edge-lit type backlight module, and the heat dissipation area of each of the luminous elements is in contact with the housing.

In the foregoing edge-lit type backlight module, any luminous element can be connected to or disconnected from other luminous elements via the connection wire, so as to replace the luminous element.

In another aspect of the present invention, a backlight source includes a plurality of luminous elements as described above. The first connector and/or the second connector of one of the luminous elements are pluggably connected to the first connector and/or the second connector of an adjacent one of the luminous elements via a connection wire having two third connectors at opposite ends thereof, so that the luminous elements are connected in series to form the backlight source. The diffusion plate is disposed above the backlight source. The housing accommodates the backlight source and the diffusion plate for constructing the lamp panel. The heat dissipation area of each of the luminous elements is in contact with the housing.

In the foregoing lamp panel, any luminous element can be connected to or disconnected from other luminous elements via the connection wire, so as to replace the luminous element.

In another aspect of the present invention, a bar-shaped luminous element includes a bar-shaped heat dissipation plate, a plurality of LED chips, a first connector, a second connector, a first circuit and a second circuit. The bar-shaped heat dissipation plate includes a die bonding area and a heat dissipation area extended from one side of the die bonding area. The body has a recess, and encompasses the bar-shaped heat dissipation plate. The recess has a first body surface, a first recess lateral wall, and a second recess lateral wall. The first body surface exposes the die bonding area. The first recess lateral wall and the second recess lateral wall respectively extend from opposite sides of the first body surface. The heat dissipation area is partially exposed on a surface of the first recess lateral wall opposite to the second recess lateral wall. An angle between the first recess lateral wall and a normal line of the first body surface is *ϕ* degrees, and an angle between the second recess lateral wall and the normal line of the first body surface is *ϕ* degrees as well, wherein 0 degrees ≦ *ϕ* < 90 degrees. The LED chips are mounted on the die bonding area. The first and second connectors are respectively disposed on opposite ends of the body. The first and the second connectors both include a first and a second electrical input ports for being pluggably connected to an external power source or other connectors. The first and the second circuits are insulated from the bar-shaped heat dissipation plate, and are positioned in the body. The LED chips are electrically connected between the first and the second circuits. The first circuit is electrically connected to the first electrical input ports of the first and the second connectors, and the second circuit is electrically connected to the second electrical input ports of the first and the second connectors.

The foregoing bar-shaped luminous element can be connected to or disconnected from the external power source or other connectors via the first connector and the second connector, so as to replace the bar-shaped luminous element.

In another aspect of the present invention, an edge-lit type backlight module includes a light guide plate, a bar-shaped light source and a housing. The light guide plate has a light outgoing surface and a light incident surface perpendicular to the light outgoing surface. The bar-shaped light source includes at least one bar-shaped luminous element as described above. The light guide plate is inserted into the recess, and the LED chips emit lights toward the light incident surface. The housing accommodates the bar-shaped light source and the light guide plate for constructing the edge-lit type backlight module. The heat dissipation area of the heat dissipation plate is in contact with the housing.

In the foregoing edge-lit type backlight module, because the bar-shaped luminous element has the first and second connectors for connecting other connectors, the bar-shaped luminous element can be connected to or disconnected from other bar-shaped luminous elements in a pluggable manner. Therefore, the user can increase or decrease the amount of the bar-shaped elements according to the length of different light guide plates in a pluggable manner.

It is to be understood that both the foregoing general description and the following detailed description are by examples, and are intended to provide further explanation of the invention as claimed.

### BRIEF DESCRIPTION OF THE DRAWINGS

The invention can be more fully understood by reading the following detailed description of the embodiment, with reference made to the accompanying drawings as follows:
Fig. 1 is a perspective view of the luminous element in accordance with one embodiment of the present invention;
Fig. 2 is a cross-sectional view of the luminous element taken along A-A' line in Fig. 1;
Fig. 3 is the circuit layout of the luminous element in Fig. 1 ;
Fig. 4 is a cross-sectional view of the luminous element in accordance with another embodiment of the present invention ;
Fig. 5 is a cross-sectional view of the luminous element in accordance with another embodiment of the present invention;
Fig. 6 is a top view of the direct type backlight module in accordance with one embodiment of the present invention;
Fig. 7 is a top view of the backlight source in Fig. 6 after disassembled;
Fig. 8 is a cross-sectional view of the direct type backlight module taken along B-B' line in Fig. 6;
Fig. 9 is a cross-sectional view of the edge-lit type backlight module in accordance with one embodiment of the present invention;
Fig. 10 is a perspective view of the bar-shaped luminous element in accordance with one embodiment of the present invention;
Fig. 11 is a top view of the bar-shaped luminous element in Fig. 10;
Fig. 12 is a cross-sectional view of the bar-shaped luminous element taken along C-C' line in Fig. 11;
Fig. 13 is a circuit layout of the bar-shaped luminous element;
Fig. 14 is a chart illustrating the relation of the angle *ϕ* to the luminance of the bar-shaped luminous element;
Fig. 15 is a chart illustrating the relation of the ratio R to the luminance of the bar-shaped luminous element;
Fig. 16 is a chart illustrating the relation of the distance D to the luminance of the bar-shaped luminous element;
Fig. 17 is a fragmentary cross-sectional view of the bar-shaped luminous element in accordance with another embodiment of the present invention;
Fig. 18 is a cross-sectional view of the edge-lit type backlight module in accordance with one embodiment of the present invention; and
Fig. 19 is a fragmentary top view of the bar-shaped light source in Fig. 18.

### DETAILED DESCRIPTION

Reference will now be made in detail to the present embodiments of the invention, examples of which are illustrated in the accompanying drawings. Wherever possible, the same reference numbers are used in the drawings and the description to refer to the same or like parts.

### Luminous element

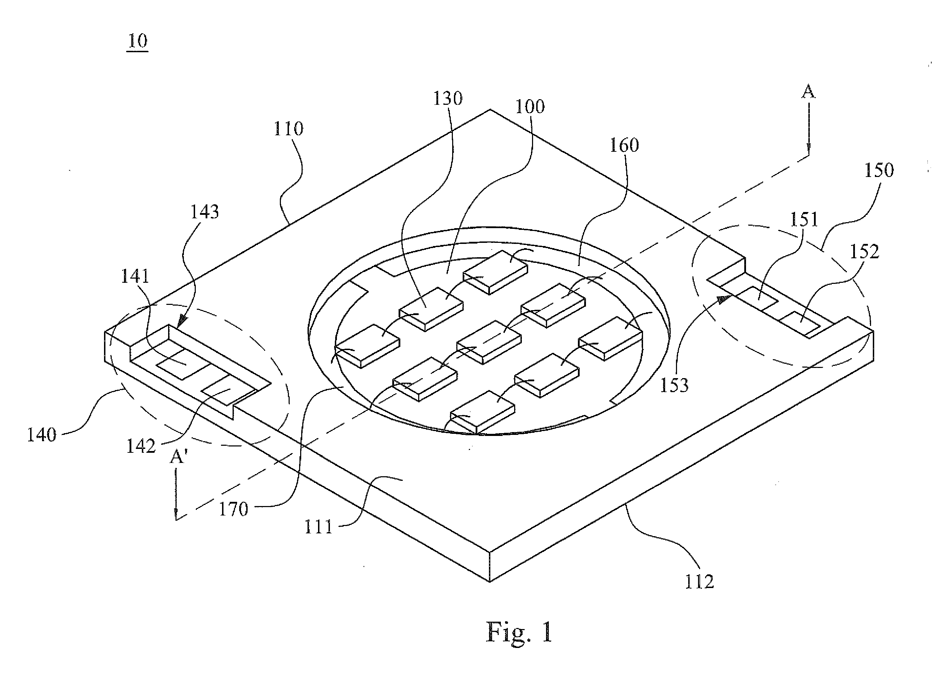

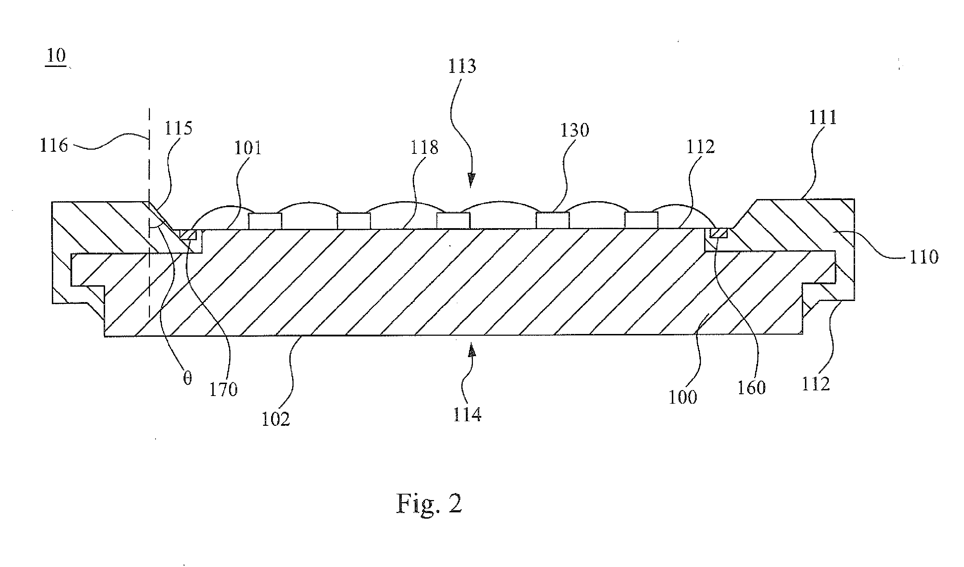

Fig. 1 is a perspective view of the luminous element 10 in accordance with one embodiment of the present invention, and Fig. 2 is a cross-sectional view of the luminous element 10 taken along A-A' line in Fig. 1. As shown in Fig. 1, the luminous element 10 includes a heat dissipation plate 100, a body 110, a plurality of LED chips 130, a first connector 140 and a second connector 150. An upper surface of the heat dissipation plate 100 has a die bonding area 101, and a lower surface of the heat dissipation plate 100 has a heat dissipation area 102. The body 110 surrounds the heat dissipation plate 100. The body 110 and includes a first body surface 111 and a second body surface 112. The first body surface 111 and the second body surface 112 are opposite to each other. The first body surface 111 includes a concave part 113. The concave part 113 exposes the die bonding area 101 of the heat dissipation plate 100. The second body surface 112 includes an opening 114. The opening 114 exposes the heat dissipation area 102. The LED chips 130 are mounted on the die bonding area 101 of the heat dissipation plate 100. In particular, the LED chips 130 are positioned in the space inner the concave part 113 of the body 110, and are mounted on the die bonding area 101 of the heat dissipation plate 100.

As shown in Fig. 1, the first connector 140 and the second connector 150 are respectively disposed on opposite edges of the first body surface 111 of the body 110. The first connector 140 includes a first electrical input port 141 and a second electrical input port 142 for being pluggably connected to an external power source or other connectors. Similarly, the second connector 150 also includes a first electrical input port 151 and a second electrical input port 152 for being pluggably connected to an external power source or other connectors.

In particular, the first connector 140 includes a socket 143 caved in one edge of the body 110. The first electrical input port 141 and the second electrical input port 142 are positioned in the socket 143. The external power source or other connector includes a protruded plug, and the plug can be inserted into the socket 143 and be electrically connected to the first electrical input port 141 and the second electrical input port 142. Similarly, the second connector 150 includes a socket 153 caved in another edge of the body 110 opposite to the first connector 140. The first electrical input port 151 and the second electrical input port 152 are positioned in the socket 153. The external power source or other connector includes a protruded plug, and the plug can be inserted into the socket 153 and be electrically connected to the first electrical input port 151 and the second electrical input port 152.

Therefore, the luminous element 10 can be connected to or disconnected from the external power source or other connectors via the first connector 140 and the second connector 150, so as to replace the luminous element 10.

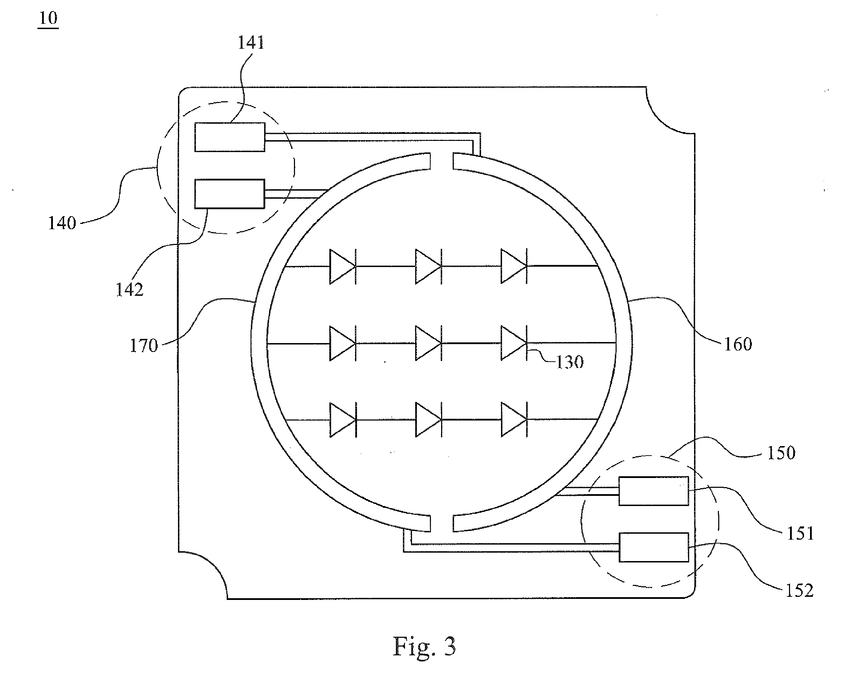

Fig. 3 is the circuit layout of the luminous element 10 in Fig. 1. As shown in Figs. 2 and 3, the luminous element 10 further includes a first circuit 160 and a second circuit 170. As shown in Fig. 2, the first circuit 160 and the second circuit 170 are disposed in the body 110, and is insulated from the heat dissipation plate 100. The LED chips 130 are electrically connected between the first circuit 160 and the second circuit 170. In particular, the first circuit 160 and the second circuit 170 are partially positioned in the concave part 113 of the body 110, so as to facilitate the LED chips 130 in the concave part 113 to electrically connect to the first circuit 160 and the second circuit 170. For example, at lease one LED chip 130 can utilize a wire to electrically connect to the first circuit 160, and at least one LED chip 130 can utilize another wire to connect to the second circuit 170. Therefore, the LED chips 130 can be connected between the first circuit 160 and the second circuit 170.

The first circuit 160 is electrically connected to the first electrical input port 141 of the first connector 140 and the first electrical input port 151 of the second connector 150. The second circuit 170 is electrically connected to the second electrical input port 142 of the first connector 140 and the second electrical input port 152 of the second connector 150.

Therefore, when the external power source is pluggably connected to the first connector 140 and the second connector 150, the LED chips 130 can be conducted via the first circuit 160 and the second circuit 170, thereby emitting lights. In other words, the luminous element 10 doesn't have to connect to the external circuit by soldering wires. Instead, the luminous element 10 can be connected to or disconnected from the external power source in a pluggable manner, thereby facilitating the user to replace the luminous element 10.

In another embodiment, as shown in Fig. 2, the edge of the concave part 113 includes a slanted wall 115. An angle between the slanted wall 115 and the normal line 116 of the first body surface 111 is *θ* degrees. The angle *θ* satisfies: 25 degrees ≦ *θ* ≦ 70 degrees. When the angle *θ* satisfies the foregoing range, more lights emitted by the LED chips 130 can be guided (in particular, be reflected) upwardly by the slanted wall 115, such that the light extraction efficiency of the luminous element 10 can be promoted.

As shown in Fig. 2, the heat dissipation plate 100 is formed of high heat dissipation metal or alloy, high heat dissipation semiconductor material, high heat dissipation ceramic material or any combination thereof. For example, material of the heat dissipation plate 100 is selected from the group consisting of aluminum, aluminum alloy, silicon carbide, semiconductor silicon, aluminium nitride, and boron nitride. It is noted that a typical LED chip utilizes MCPCB (metal core PCB) as the substrate. However, because the MCPCB includes an isolation layer having high thermal resistance, the heat dissipation plate 100 formed by the foregoing material has the heat dissipation effect better than the typical MCPCB has, thereby facilitating to dissipate the heat generated by the LED chip 130, and to reduce the luminous decay issue owning high temperature. Therefore, when the luminous element 10 works for a long period of time, it still exhibits the excellent light extraction efficiency. For example, if the luminance of the luminous element 10 is A when it is just activated, and the luminance of the luminous element 10 is B when it works for 10 minutes, the relation between the luminance A and the luminance B satisfies: 96.20%×A ≦B≦ 100%×A. Therefore, the decay ratio of the luminance is less than 5%.

In another embodiment, the luminous element 10 further includes a reflective layer 118. The reflective layer 118 is disposed on the die bonding area 101 of the heat dissipation plate 100. The light emitted by the LED chip 130 toward the die bonding area 101 can be reflected by the reflective layer 118 out of the luminous element 10, so as to promote the light extraction efficiency of the luminous element 10.

The reflective layer 118 is formed of ceramic material with high reflectivity. For example, the ceramic material with high reflectivity is selected from the group consisting of titanium dioxide, silicon dioxide, aluminum oxide and zirconium oxide.

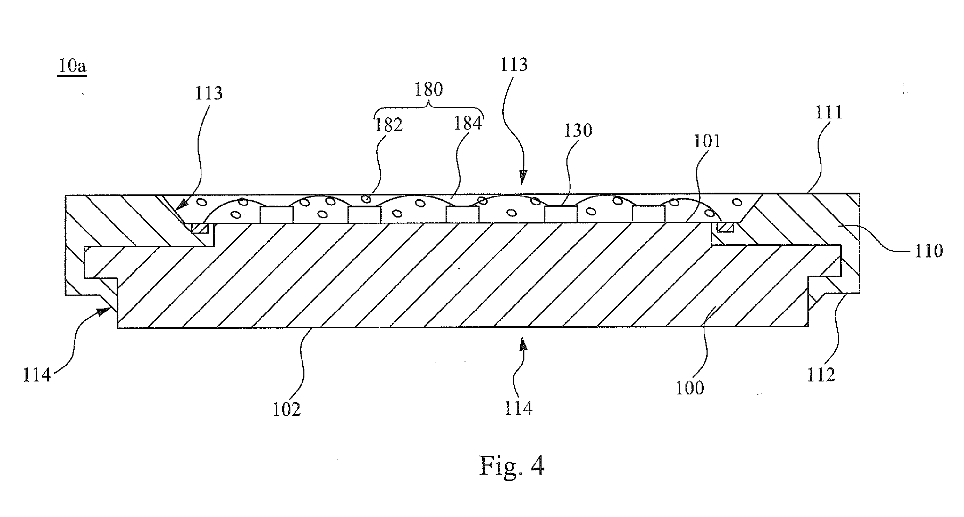

Fig. 4 is a cross-sectional view of the luminous element 10a in accordance with another embodiment of the present invention. The main difference between this embodiment and the luminous element 10 in Fig. 2 is that: the luminous element 10a further includes a wavelength converting unit 180. The wavelength converting unit 180 can convert some first lights emitted by the LED chips 130 to second lights with longer wavelength. The second lights can be blended with the rest first lights, which are not converted, so as to form a light in white or other colors. In other words, when the viewer views the wavelength converting unit 180, the viewer can see the light in white or other colors, rather than the original colored light emitted by LED chip 130.

In particular, the wavelength converting unit 180 is an encapsulating glue 184 doped with wavelength converting material 182. The encapsulating glue 184 is filled in the concave part 113 and covers the LED chips 130. When the LED chip 130 emits first lights, some first lights excite the wavelength converting material 182 and are converted to second lights. The wavelength of the second lights can be greater than the wavelength of the first lights. These first lights and second lights can be blended in the encapsulating glue 184, thereby forming a light in white or other colors.

The wavelength converting material 182 can be phosphor, pigment or dye. In particular, the wavelength converting material 182 is a phosphor selected from the group consisting of the garnet, the silicate, the nitride, the nitrogen, and the sulfide activated by europium or cerium.

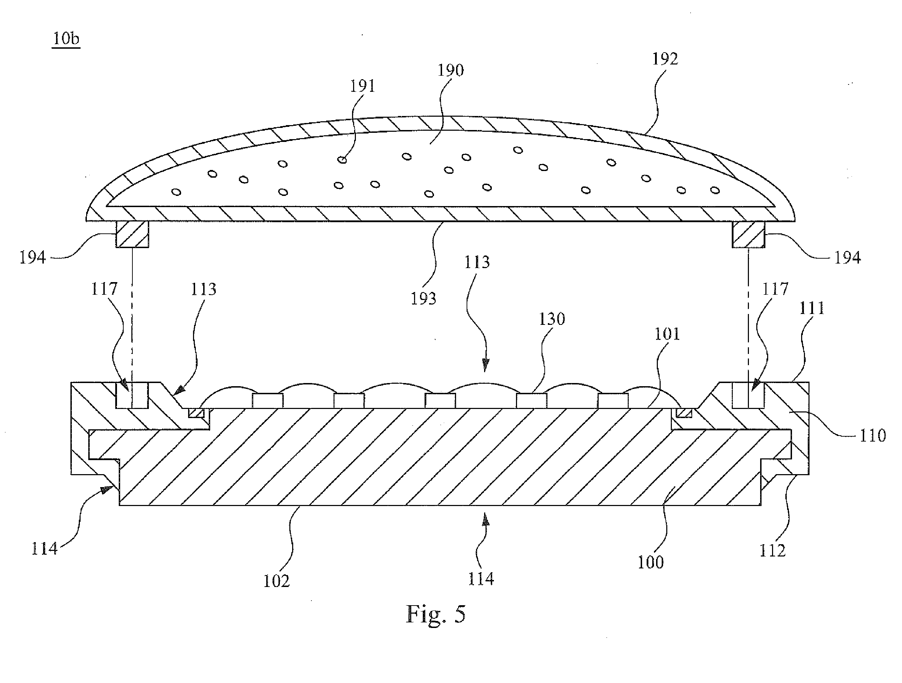

Fig. 5 is a cross-sectional view of the luminous element 10b in accordance with another embodiment of the present invention. The main difference between this embodiment and the luminous element 10a in Fig. 4 is that: the wavelength converting unit 190 is positioned on the optical paths of the first lights emitted by the LED chips 130, and is spaced apart from the LED chips 130. In other words, the wavelength converting unit 190 does not cover or in contact with the LED chip 130. Instead, the wavelength converting unit 190 is spatially separated from the LED chips 130. In particular, the first body surface 111 of the body 110 has a plurality of securing holes 117. The wavelength converting unit 190 is an optical lens 192 having wavelength converting material 191. The optical lens 192 includes a plurality of securing legs 194. The securing legs 194 are connected to the bottom surface 193 of the optical lens 192 facing to the LED chips 130. The optical lens 192 is secured above the LED chips 130 by inserting the securing legs 194 in the securing holes 117, such that the wavelength converting unit 190 is spaced apart from the LED chips 130.

In another embodiment, the distance between the securing legs 194 of the optical lens 192 equals to the distance between the securing holes 117 on the body 110, so that each securing leg 194 can be inserted into a corresponding securing hole 117. The shape and size of the securing leg 194 are the same as the shape and size of the securing hole 117, so that the securing leg 194 can be tightly secured in the securing hole 117, thereby securing the optical lens 192.

In another embodiment, the wavelength converting material 191 is a phosphor selected from the group consisting of the garnet, the silicate, the nitride, the nitrogen, and the sulfide activated by europium or cerium.

In another embodiment, the optical lens 192 includes the quantum dot material therein for providing the ability of converting wavelength. The interior of the optical lens 192 is vacuum or filled with noble gas, so as to prevent the quantum dot material from oxidizing. The quantum dot material refers to the material that the sizes thereof along three dimensions are all less than the wavelength of an electron. The quantum dot material is selected from the group consisting of the zinc sulfide and the zinc selenide, and the zinc cadmium.

Further, in another embodiment, the first connector 140 and/or the second connector can also be disposed on the second body surface 112 of the body 110 (not shown).

### First Application of the luminous element

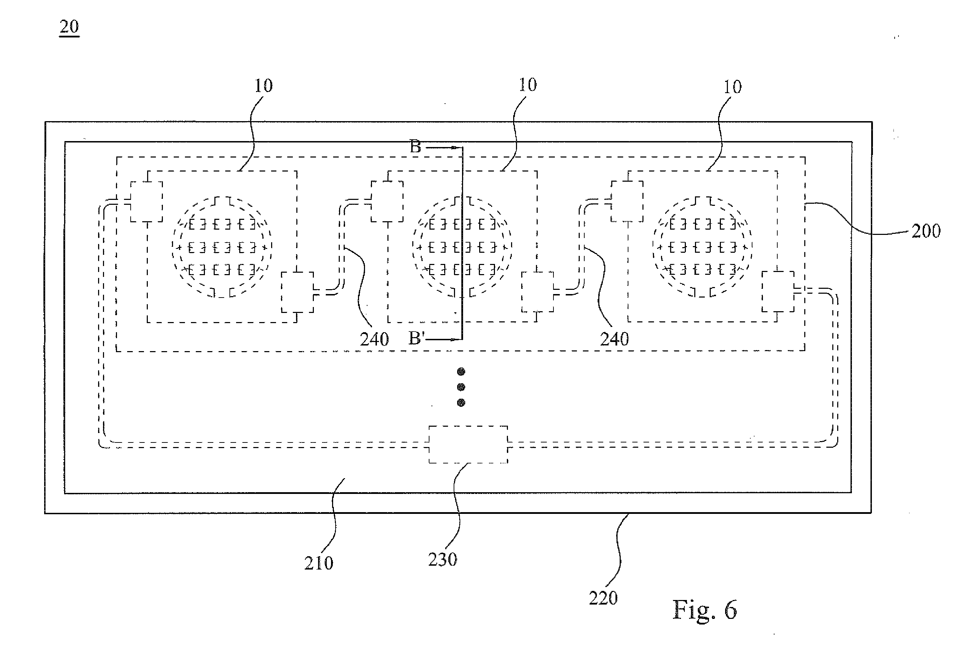

The luminous element 10, 10a or 10b can be at least applied on a panel or a direct type backlight module 20 of a lamp panel. Fig. 6 is a top view of the direct type backlight module 20 in accordance with one embodiment of the present invention. As shown in Fig. 6, the direct type backlight module 20 includes a backlight source 200, a diffusion plate 210, a housing 220 and a driving circuit 230. The diffusion plate 210 is disposed above the backlight source 200. The backlight source 200 includes a plurality of luminous elements 10 as described above. The luminous elements 10 are connected in series to form the backlight source 200. The driving circuit 230 is electrically connected to the backlight source 200, so as to drive every luminous element 10 to emit light. The housing 220 accommodates the backlight source 200 and the diffusion plate 210 for constructing the direct type backlight module 20.

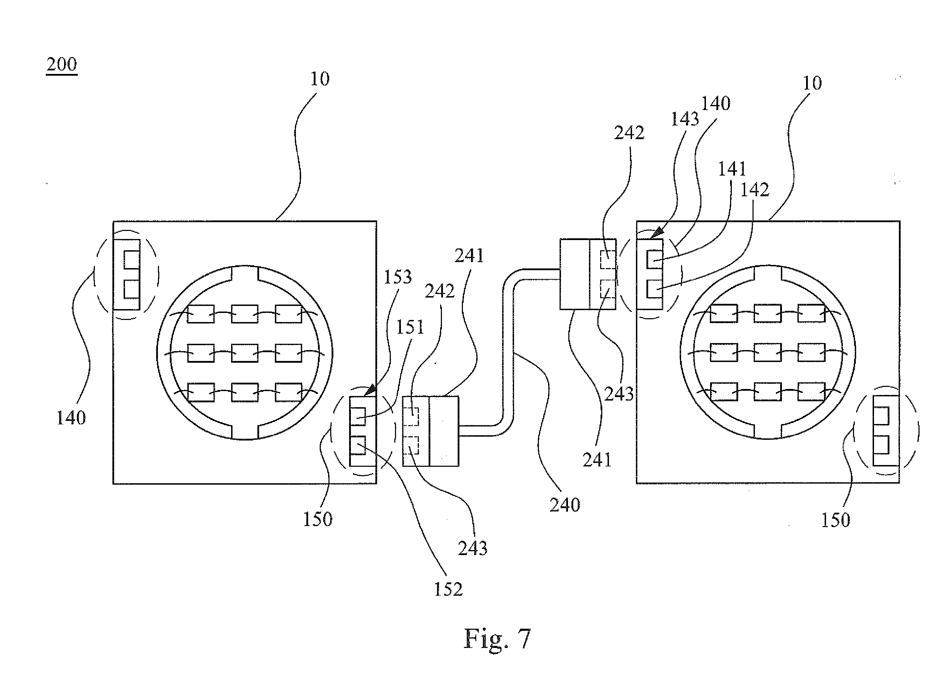

Fig. 7 is a top view of the backlight source 200 in Fig. 6 after disassembled. As shown in Fig. 7, the first connector 140 and/or the second connector 150 of one of the luminous elements 10 are pluggably connected to the first connector 140 and/or the second connector 150 of an adjacent one of the luminous elements 10 via a connection wire 240 having two third connectors 241 at opposite ends thereof, so that plural luminous elements 10 can be connected in series to form the backlight module 200.

In particular, in Fig. 7, the third connector 241 at the left end of the connection wire 240 has a first electrical connection port 242 and a second electrical connection port 243. The first electrical connection port 242 and the second electrical connection port 243 can be inserted into the socket 153 of the second connector 150 of the luminous element 10 at the left side of the connection wire 240, and can be respectively connected to the first electrical input port 151 and the second electrical input port 152 in the socket 153. Similarly, the third connector 241 at the right end of the connection wire 240 has a first electrical connection port 242 and a second electrical connection port 243. The first electrical connection port 242 and the second electrical connection port 243 can be inserted into the socket 143 of the first connector 140 of the luminous element 10 at the right side of the connection wire 240, and can be respectively connected to the first electrical input port 141 and the second electrical input port 142 in the socket 143. Therefore, adjacent two luminous elements 10 can be pluggably connected by the connection wire 240. In other words, any luminous element 10 can be connected to or disconnected from other luminous element 10 by the connection wire 240, so as to facilitate the user to replace the luminous element 10.

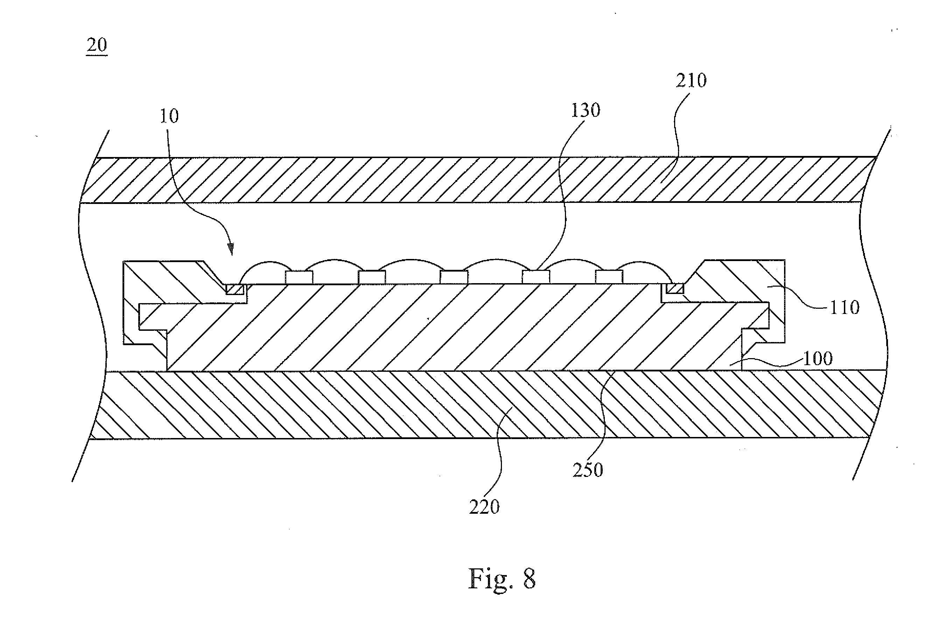

Fig. 8 is a cross-sectional view of the direct type backlight module 20 taken along B-B' line in Fig. 6. As shown in Fig. 8, the luminous element 10 is accommodated between the diffusion plate 210 and the housing 220. The LED chip 130 of the luminous element 10 emits the light toward the diffusion plate 210. The diffusion plate 210 can diffuse the light, so as to make the illumination distribution more uniform. The heat dissipation area (not shown in this figure) of the heat dissipation plate 100 of the luminous element 10 is in contact with the housing 220. Therefore, the thermal energy generated by the LED chip 130 can be transferred to the housing 220 via the heat dissipation plate 100, and be dissipated to the ambience via the housing 220.

In another embodiment, a heat conductive glue 250 is sandwiched between the heat dissipation area 102 of each of the luminous elements 10 and the housing 220, so as to transfer the thermal energy from the heat dissipation plate 100 to the housing 220.

Although the backlight source 200 is assembled by luminous elements 10 in Figs. 6 to 8, the present invention is not limited to the luminous elements 10. In other embodiments, the backlight source 200 can also be assembled by luminous elements 10a (See Fig. 4) or luminous elements 10b (See Fig. 5).

### Second application of the luminous element

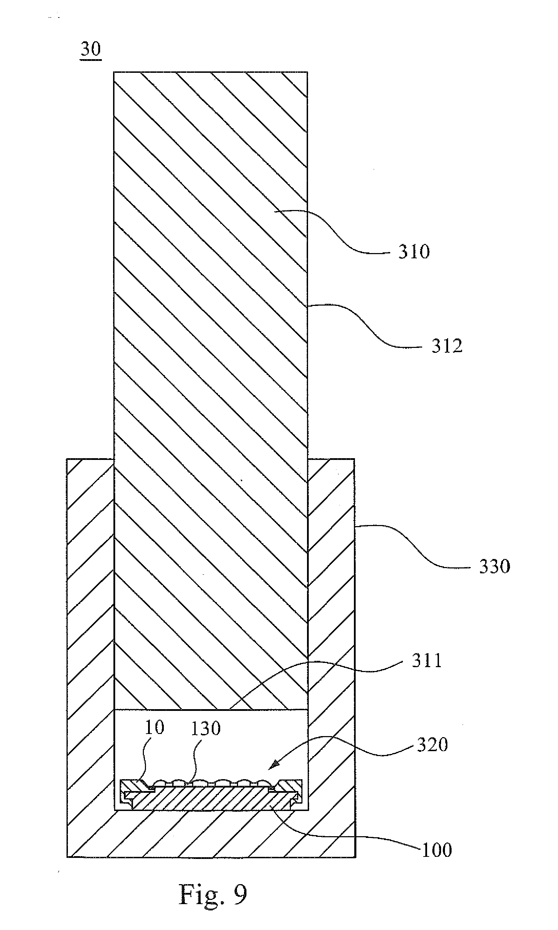

The luminous element 10, 10a or 10b can be at least applied on at least one edge-lit type backlight module 30. Fig. 9 is a cross-sectional view of the edge-lit type backlight module 30 in accordance with one embodiment of the present invention. As shown in Fig. 9, the edge-lit type backlight module 30 includes a light guide plate 310, a light bar 320 and a housing 330. The light guide plate 310 has a light outgoing surface 312 and a light incident surface 311 perpendicular to the light outgoing surface 312. The light bar 320 faces toward the light incident surface 311, such that the light bar 320 emits a light toward the light incident surface 311. The housing 330 accommodates the light bar 320 and the light guide plate 310 for constructing the edge-lit type backlight module 30. When the luminous element 10 on the light bar 320 emits lights, the lights can propagate into the light guide plate 310 through the light incident surface 311, and can propagate out of the edge-lit type backlight module 30 through the light outgoing surface 312. The top view of the light bar 320 is as shown as the backlight source 200 in Fig. 7. Referring to Fig. 7, the light bar 320 includes a plurality of luminous elements 10. The edge-lit type backlight module 30 includes a driving circuit, such as the driving circuit 230 in Fig. 6, and the driving circuit is electrically connected to the light bar 320. In particular, the driving circuit can be electrically connected to the luminous element 10 on the light bar 320, so as to drive the luminous element 10 to emit lights. The first connector 140 and/or the second connector 150 of one of the luminous elements 10 are pluggably connected to the first connector 140 and/or the second connector 150 of an adjacent one of the luminous elements 10 via a connection wire 240 having two third connectors 241 at opposite ends thereof, so that the luminous elements 10 are connected in series. The specific plugging manner can be referred to the related description regarding Fig. 7, and is not described repeatedly.

As shown in Fig. 9, the LED chip 130 of each luminous element 10 emits lights toward the light incident surface 311 of the light guide plate 310. The heat dissipation area (not shown in this figure) of the light guide plate 100 of the luminous element 10 is in contact with the housing 330. Therefore, the thermal energy generated by the LED chip 130 can be transferred to the housing 330 via the heat dissipation plate 100, and can be dissipated to the ambience via the housing 330.

In another embodiment, a heat conductive glue, such as the heat conductive glue 250 in Fig. 8, is sandwiched between the heat dissipation area (not shown in this figure) of the luminous elements 10 and the housing 330, so as to transfer the thermal energy from the heat dissipation plate 100 to the housing 330.

Although the light bar 320 includes the luminous elements 10, the present invention is not limited to the luminous elements 10. In other embodiments, the light bar 320 can also include luminous elements 10a (See Fig. 4) or luminous elements 10b (See Fig. 5).

### Bar-shaped luminous element

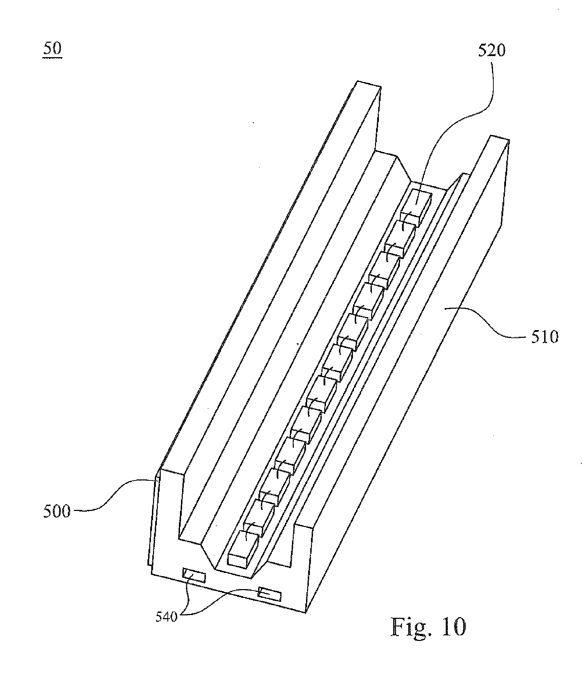

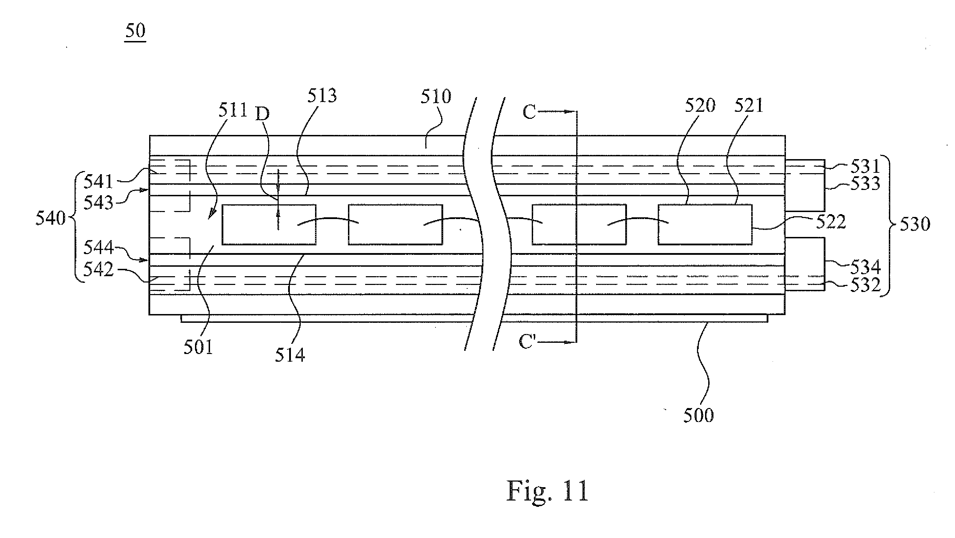

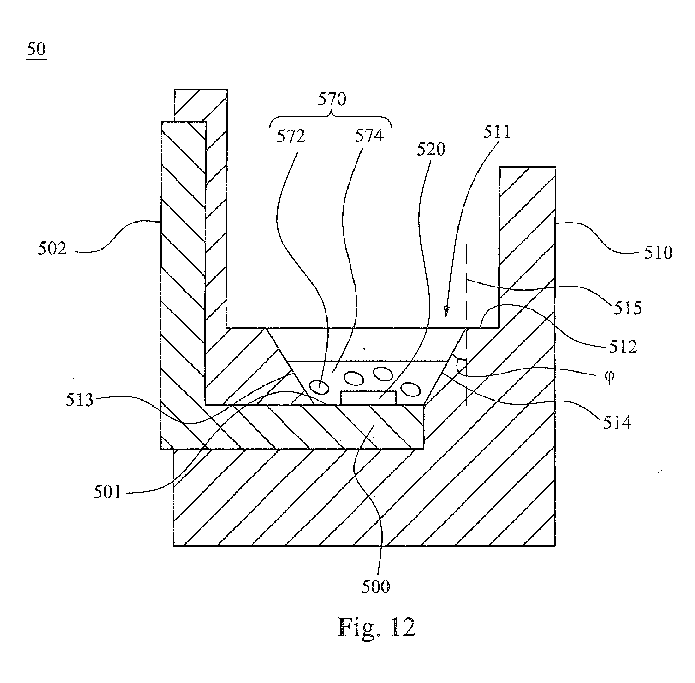

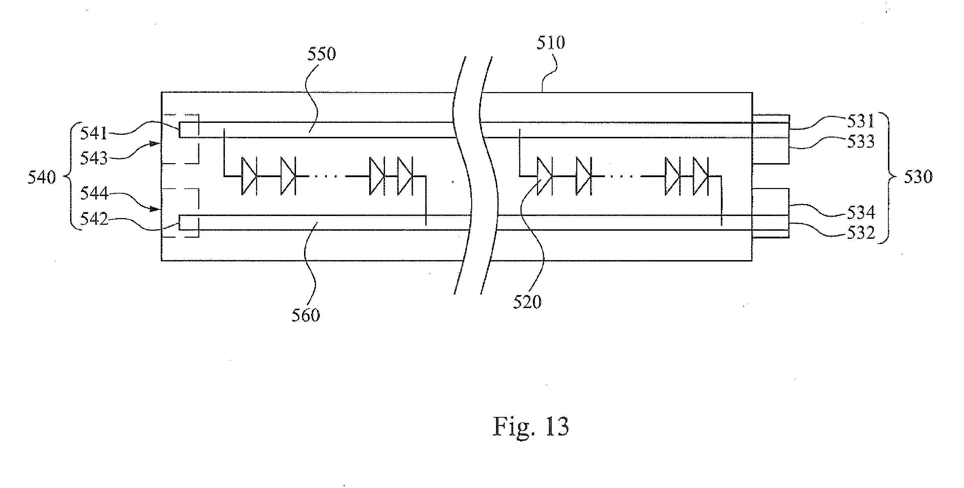

Fig. 10 is a perspective view of the bar-shaped luminous element 50 in accordance with one embodiment of the present invention. Fig. 11 is a top view of the bar-shaped luminous element 50 in Fig. 10. Fig. 12 is a cross-sectional view of the bar-shaped luminous element 50 taken along C-C' line in Fig. 11. Fig. 13 is a circuit layout of the bar-shaped luminous element 50. As shown in Figs. 10-13, the bar-shaped luminous element 50 includes a bar-shaped heat dissipation plate 500, a body 510, a plurality of LED chips 520, a first connector 530, a second connector 540, a first circuit 550 and a second circuit 560. As shown in Fig. 12, the bar-shaped heat dissipation plate 500 includes a die bonding area 501 and a heat dissipation area 502 extended from one side of the die bonding area 501. The body 510 has a recess 511, and the body 510 encompasses the bar-shaped heat dissipation plate 500. The recess 511 has a first body surface 512, a first recess lateral wall 513, and a second recess lateral wall 514. The first body surface 512 exposes the die bonding area 501. The first recess lateral wall 513 and the second recess lateral wall 514 respectively extend from opposite sides of the first body surface 512. The heat dissipation area 502 is partially exposed on a surface of the first recess lateral wall 513 opposite to the second recess lateral wall 514. An angle between the first recess lateral wall 513 and a normal line 515 of the first body surface 512 is *ϕ* degrees, and an angle between the second recess lateral wall 514 and the normal line 515 of the first body surface 512 is *ϕ* degrees as well, wherein 0 degrees ≦ *ϕ* < 90 degrees. The LED chips 520 are mounted on the die bonding area 501.

As shown in Figs. 11 and 13, the first connector 530 and the second connector 540 are respectively disposed on opposite ends of the body 510. The first connector 530 includes a first electrical input port 531 and a second electrical input port 532 for being pluggably connected to an external power source or other connectors. Similarly, the second connector 540 includes a first electrical input port 541 and a second electrical input port 542 for being pluggably connected to an external power source or other connectors.

The first circuit 550 and the second circuit 560 are insulated from the bar-shaped heat dissipation plate 500, and are disposed in the body 510. As shown in Fig. 13, the LED chips 520 are electrically connected between the first circuit 550 and the second circuit 560. The first circuit 550 is electrically connected to the first electrical input port 531 of the first connector 530 and the first electrical input port 541 of the second connector 540. The second circuit 560 is electrically connected to the second electrical input port 532 of the first connector 530 and the second electrical input port 542 of the second connector 540.

Therefore, when the external power source is pluggably connected to the first connector 530 and the second connector 540, the LED chip 520 can be conducted via the first circuit 550 and the second circuit 560, thereby emitting lights. In other words, the bar-shaped luminous element 50 doesn't have to connect to the external circuit by soldering wires. Instead, the luminous element 50 can be connected to or disconnected from the external power source in a pluggable manner, thereby facilitating the user to replace the bar-shaped luminous element 50.

In another embodiment, as shown in Figs. 11 and 13, the first connector 530 includes a first plug 533 and a second plug 534 protruded on one end of the body 510. The first plug 533 and the second plug 534 respectively accommodate the first electrical input port 531 and the second electrical input port 532. The second connector 540 includes a first socket 543 and a second socket 544. The first socket 543 and the second socket 544 are both caved in another end of the body 510 opposite to the first connector 530. The first socket 543 and the second socket 544 respectively accommodate the first electrical input port 541 and the second electrical input port 542.

The user can insert the first plug 533 and the second plug 534 of one bar-shaped luminous element 50 into the first socket 543 and the second socket 544 of another bar-shaped luminous element 50, such that these bar-shaped luminous elements 50 can be electrically connected to each other. Contrarily, the user can also pull the first plug 533 and the second plug 534 of one bar-shaped luminous element 50 out of the first socket 543 and the second socket 544 of another bar-shaped luminous element 50, such that two connected bar-shaped luminous elements 50 can be disconnected.

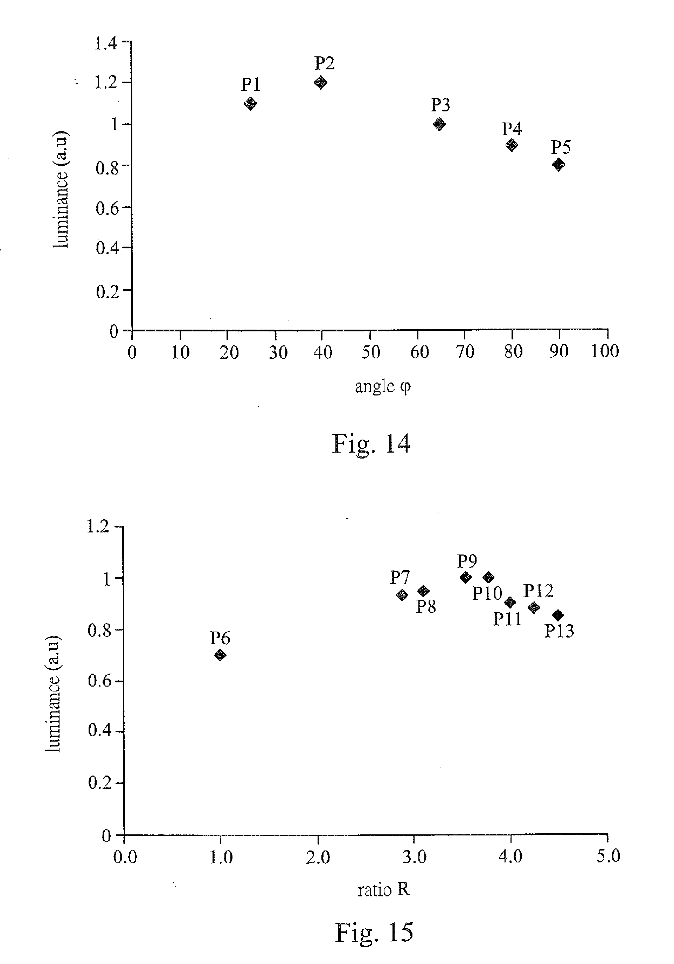

Fig. 14 is a chart illustrating the relation of the angle *ϕ* to the luminance of the bar-shaped luminous element 50. In Fig. 14, the unit of the luminance of the bar-shaped luminous element 50 is arbitrary unit (a.u.). The following table includes the data in Fig. 14.

**Table 1**

| coordinate point | angle *ϕ* (degrees) | Luminance of the bar-shaped luminous element 50 (a.u.) |
|---|---|---|
| P1 | 25 | 1.1 |
| P2 | 40 | 1.2 |
| P3 | 65 | 1 |
| P4 | 80 | 0.9 |
| P5 | 90 | 0.8 |

Based on Fig. 14 and Table 1, it is clear that the bar-shaped luminous element 50 shows high luminance when the angle *ϕ* satisfies: 25 degrees≦ *ϕ* ≦65 degrees.

In another embodiment, as shown in Fig. 11, every LED chips 520 is a cuboid, namely, the surface of every LED chip 520 is rectangular. In other words, the LED chip 520 has two opposite longer edges 521 and two opposite shorter edges 522 adjoining to the longer edges 521. The length of the longer edge 521 is a, and the length of the shorter edge 522 is b. The length a of the longer edge 521 and the length b of the shorter edge 522 define a ratio R, and R=a/b.

Fig. 15 is a chart illustrating the relation of the ratio R to the luminance of the bar-shaped luminous element 50. In Fig. 15, the unit of the luminance of the bar-shaped luminous element 50 is arbitrary unit (a.u.). The following table includes the data in Fig. 15.

**Table 2**

| Coordinate point | R | Luminance of the bar-shaped luminous element 50 (a.u.) |
|---|---|---|
| P6 | 1.0 | 0.7 |
| P7 | 2.9 | 0.93 |
| P8 | 3.1 | 0.95 |
| P9 | 3.6 | 1 |
| P10 | 3.8 | 1 |
| P11 | 4.0 | 0.9 |
| P12 | 4.3 | 0.88 |
| P13 | 4.5 | 0.85 |

Based on Fig. 15 and Table 2, it is clear that the bar-shaped luminous element 50 shows high luminance when the ratio R satisfies: 1≦R≦5. Further, when the ratio R satisfies: 3≦R≦4, the bar-shaped luminous element 50 shows higher luminance.

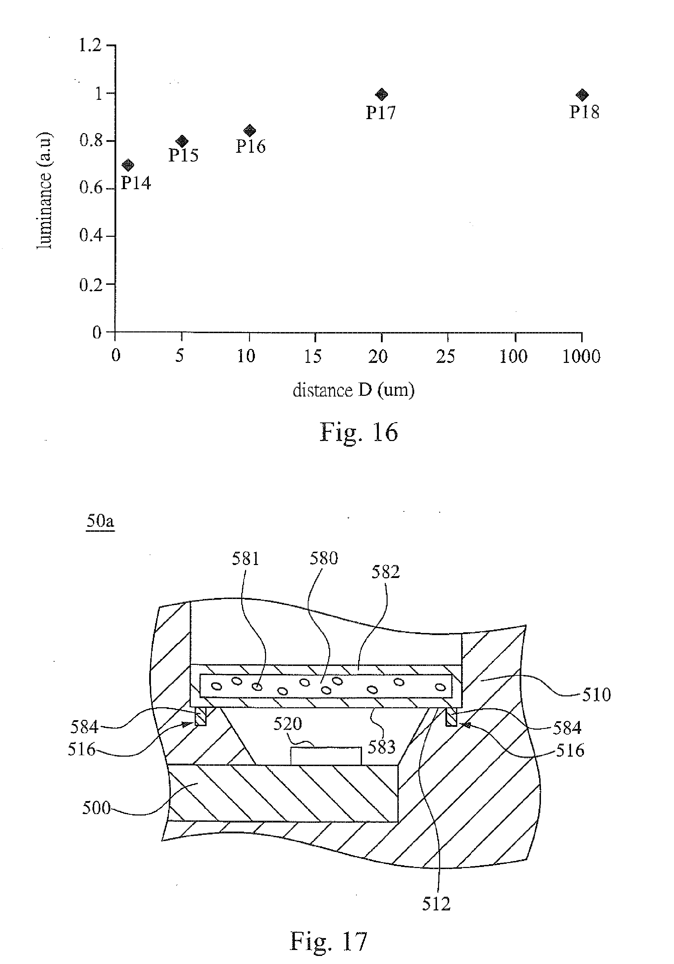

In another embodiment, as shown in Fig. 11, each of the LED chips 520 is apart from the boundary between the first recess lateral wall 513 and the die bonding area 501 at a distance D, and is also apart from the boundary between the second recess lateral wall 514 and the die bonding area 501 at the distance D. Fig. 16 is a chart illustrating the relation of the distance D to the luminance of the bar-shaped luminous element 50. In Fig. 16, the unit of the luminance of the bar-shaped luminous element 50 is arbitrary unit (a.u.). The unit of the distance D is *µ*m. The following table includes the data in Fig. 16.

**Table 3**

| Coordinate point | distance D (*µ*m) | luminance of the bar-shaped luminous element 50 (a.u.) |
|---|---|---|
| P14 | 1 | 0.7 |
| P15 | 5 | 0.8 |
| P16 | 10 | 0.85 |
| P17 | 20 | 1 |
| P18 | 1000 | 1 |

Based on Fig. 16 and Table 3, it is clear that the bar-shaped luminous element 50 shows high luminance when the distance D satisfies: 1 *µ*m≦D≦5 *µ*m. In another embodiment, the bar-shaped luminous element 50 includes a reflective layer (not shown in this figure) disposed on the die bonding area 501 of the bar-shaped heat dissipation plate 500. The light emitted by the LED chip 520 toward the die bonding area 501 can be reflected out of the bar-shaped luminous element 50, so that the light extraction efficiency of the bar-shaped luminous element 50 can be promoted.

The reflective layer is formed of ceramic material with high reflectivity. For example, the ceramic material with high reflectivity is selected from the group consisting of titanium dioxide, silicon dioxide, aluminum oxide and zirconium oxide.

As shown in Fig. 12, the bar-shaped luminous element 50 includes a wavelength converting unit 570. The wavelength converting unit 570 can convert some first lights emitted by the LED chips 520 to second lights with longer wavelength. The second lights are blended with the rest first lights, which are not converted, so as to form a light in white or other colors. In other words, when the viewer views the wavelength converting unit 570, the viewer can see the light in white or other colors, rather than the original colored light emitted by LED chip 520.

In particular, the wavelength converting unit 570 is an encapsulating glue 574 doped with wavelength converting material 572. The encapsulating glue 574 is filled in the concave part 511 and covers the LED chips 520. When the LED chip 520 emits first lights, some first lights excite the wavelength converting material 572 and are converted to second lights. The wavelength of the second lights can be greater than the wavelength of the first lights. These first lights and the second lights can be blended in the encapsulating glue 574, thereby forming a light in white or other colors.

The wavelength converting material 572 can be phosphor, pigment or dye. In particular, the wavelength converting material 572 is a phosphor selected from the group consisting of the garnet, the silicate, the nitride, the nitrogen, and the sulfide activated by europium or cerium.

Fig. 17 is a fragmentary cross-sectional view of the bar-shaped luminous element 50a in accordance with another embodiment of the present invention. The main difference between this embodiment and the bar-shaped luminous element 50 in Fig. 12 is that: the wavelength converting unit 580 is positioned on the optical paths of the first lights emitted by the LED chips 520, and is spaced apart from the LED chips 520. In other words, the wavelength converting unit 580 does not cover or in contact with the LED chip 520. Instead, the wavelength converting unit 580 is spatially separated from the LED chips 520.

In particular, in another embodiment, the first body surface 512 of the body 510 has a plurality of securing holes 516. The wavelength converting unit 580 is an optical lens 582 having wavelength converting material 581. The optical lens 582 includes a plurality of securing legs 584. The securing legs 584 are connected to the bottom surface 583 of the optical lens 582 facing to the LED chips 520. The optical lens 582 is secured above the LED chips 520 by inserting the securing legs 584 in the securing holes 516, such that the wavelength converting unit 580 is spaced apart from the LED chips 520. More particularly, the distance between the securing legs 584 of the optical lens 582 equals to the distance between the securing holes 516 on the body 510, so that each securing leg 584 can be inserted into a corresponding securing hole 516. In another embodiment, the shape and size of the securing leg 584 are the same as the shape and size of the securing hole 516, so as to secure the optical lens 582.

In another embodiment, the wavelength converting material 581 is a phosphor, a pigment or a dye. In particular, the wavelength converting material 581 is the phosphor selected from the group consisting of the garnet, the silicate, the nitride, the nitrogen, and the sulfide activated by europium or cerium.

In another embodiment, the optical lens 582 includes the quantum dot material therein for providing the ability of converting wavelength. The interior of the optical lens 582 is vacuum or filled with noble gas, so as to prevent the quantum dot material from oxidizing. The quantum dot material refers to the material that the sizes thereof along three dimensions are all less than the wavelength of an electron. The quantum dot material is selected from the group consisting of the zinc sulfide and the zinc selenide, and the zinc cadmium.

### Application of the bar-shaped luminous element

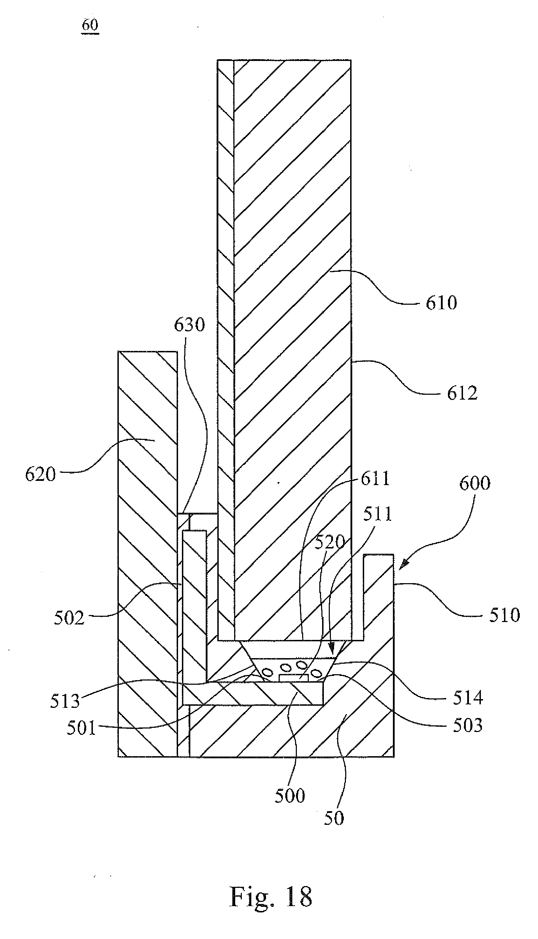

The bar-shaped luminous elements 50 and 50a can be at least applied on an edge-lit type backlight module 60. Fig. 18 is a cross-sectional view of the edge-lit type backlight module 60 in accordance with one embodiment of the present invention. As shown in Fig. 18, an edge-lit type backlight module 60 includes a bar-shaped light source 600, a light guide plate 610 and a housing 620. The light guide plate 610 has a light incident surface 611 and a light outgoing surface 612 perpendicular to the light incident surface 611. The bar-shaped light source 600 includes at least one bar-shaped luminous element 50 as described above. The light guide plate 610 is inserted into the recess 511, and the LED chips 520 emit lights toward the light incident surface 611. The housing 620 accommodates the bar-shaped light source 600 and the light guide plate 610 for constructing the edge-lit type backlight module 60.

The heat dissipation area 502 of the bar-shaped heat dissipation plate 500 is in contact with the housing 620. Therefore, the thermal energy generated by the LED chip 520 on the die bonding area 501 can be transferred to the heat dissipation area 502 via the bar-shaped. Therefore, the thermal energy generated by the LED chip 130 can be transferred to the housing 220 via the heat dissipation plate 100, and be dissipated to the ambience via the housing 220.

In another embodiment, a heat conductive glue 250 is sandwiched between the heat dissipation area 102 of each of the luminous elements 10 and the housing 220, so as to transfer the thermal energy from the heat dissipation plate 100 to the housing 220 by the bar-shaped heat dissipation plate 500, and be dissipated to the ambience via the housing 620.

In another embodiment, a heat conductive glue 630 is sandwiched between the heat dissipation area 502 of the bar-shaped heat dissipation plate 500 and the housing 620, so as to transfer the thermal energy from the LED chip 520 to the housing 620.

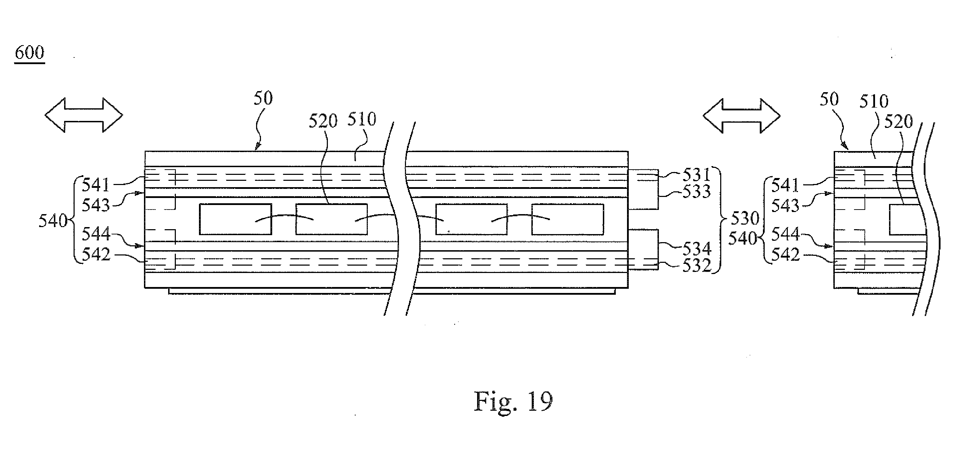

Fig. 19 is a fragmentary top view of the bar-shaped light source 600 in Fig. 18. In another embodiment, the edge-lit type backlight source 60 in Fig. 19 includes a driving circuit electrically connected to the bar-shaped luminous element 50, so as to drive the LED chip 520 on the bar-shaped luminous element 50 to emit lights.

In another embodiment, as shown in Fig. 19, the bar-shaped light source 600 is assembled by a plurality of the bar-shaped luminous elements 50. The first connector 530 and the second connector 540 of each of the bar-shaped luminous elements 50 are pluggably connected to the first connector 530 or the second connector 540 of an adjacent one of the bar-shaped luminous elements 50, so that the bar-shaped luminous elements 50 are connected in series.

In particular, as shown in Fig. 19, the first plug 533 and the second plug 534 of the bar-shaped luminous element 50 on the left side in the figure can be inserted into the first socket 543 and the second socket 544 of the bar-shaped luminous element 50 on the right side in the figure, such that these bar-shaped luminous elements 50 can be electrically connected to each other.

In the foregoing edge-lit type backlight module 60, because the bar-shaped luminous element 50 has the first connector 530 and the second connector 540 for connecting other connectors, the bar-shaped luminous element 50 can be connected to or disconnected from other bar-shaped luminous elements 50 in a pluggable manner. Therefore, the user can increase or decrease the amount of the bar-shaped elements 50 according to the length of different light guide plates 610 in a pluggable manner.

Although the bar-shaped backlight source 600 is assembled by bar-shaped luminous elements 50 in Figs. 18 and 19, the present invention is not limited to the luminous elements 50. In other embodiments, the bar-shaped backlight source 600 can also be assembled by luminous elements 50a (See Fig. 17).

## Claims

1. A luminous element, **characterized by** comprising:
a heat dissipation plate comprising a first surface and a second surface, the first surface having a die bonding area, and the second surface having a heat dissipation area;
a body surrounding the heat dissipation plate, the body comprising a first body surface and a second body surface opposite to the first body surface, wherein the first body surface comprises a concave part exposing the die bonding area, and the second body surface comprises an opening exposing the heat dissipation area;
a plurality of LED chips mounted on the die bonding area;
a first and a second connectors respectively disposed on the edge of the first body surface or the edge of the second body surface of the body, and the first and the second connectors both comprise a first and a second electrical input port for being pluggably connected to an external power source or other connectors; and
a first and a second circuits disposed in the body, wherein the LED chips are electrically connected between the first and the second circuits, and the first circuit is electrically connected to the first electrical input ports of the first and the second connectors, and the second circuit is electrically connected to the second electrical input ports of the first and the second connectors.

2. The luminous element of claim 1, **characterized by** further comprising a wavelength converting unit for converting some first lights emitted by the LED chips to second lights with longer wavelength, wherein the second lights are blended with the rest first lights which are not converted, so as to form a light in white or other colors.

3. The luminous element of claim 2, **characterized in that** the wavelength converting unit is an encapsulating glue doped with wavelength converting material, and the encapsulating glue covers the LED chips.

4. The luminous element of claim 2, **characterized in that** the wavelength converting unit is positioned on the optical paths of the first lights emitted by the LED chips, and is spaced apart from the LED chips.

5. The luminous element of claim 4, **characterized in that** the first body surface comprises a plurality of securing holes, and the wavelength converting unit is an optical lens having wavelength converting material, and the optical lens comprises a plurality of securing legs, and the optical lens is secured above the LED chips by inserting the securing legs in the securing holes.

6. The luminous element of claim 5, **characterized in that** the optical lens comprises quantum dot material therein, and the interior of the optical lens is vacuum or filled with noble gas.

7. The luminous element of claim 1, **characterized in that** the concave part comprises a slanted wall, and an angle between the slanted wall and the normal line of the first body surface is *θ* degrees, wherein 25 degrees≦ *θ* ≦ 70 degrees.

8. A direct type backlight module, **characterized by** comprising:
a backlight source comprising a plurality of luminous elements of claim 1, wherein the first connector and/or the second connector of one of the luminous elements are pluggably connected to the first connector and/or the second connector of an adjacent one of the luminous elements via a connection wire having two third connectors at opposite ends thereof, so that the luminous elements are connected in series to form the backlight source;
a diffusion plate disposed above the backlight source; and
a housing accommodating the backlight source and the diffusion plate for constructing the direct type backlight module, wherein the heat dissipation area of each of the luminous elements is in contact with the housing.

9. An edge-lit type backlight module, **characterized by** comprising:
a light guide plate having a light outgoing surface and a light incident surface perpendicular to the light outgoing surface;
a light bar facing toward the light incident surface, such that the light bar emits a light toward the light incident surface, wherein the light bar comprises a plurality of luminous elements of claim 1, wherein the first connector and/or the second connector of the luminous elements are/is pluggably connected to the first connector and/or the second connector of another one of the luminous elements via a connection wire having two third connectors at both ends thereof, so that the luminous elements are connected in series; and
a housing accommodating the light bar and the light guide plate for constructing the edge-lit type backlight module, and the heat dissipation area of each of the luminous elements is in contact with the housing.

10. A lamp panel, **characterized by** comprising:
a backlight source comprising a plurality of luminous elements of claim 1, wherein the first connector and/or the second connector of one of the luminous elements are/is pluggably connected to the first connector and/or the second connector of an adjacent the luminous elements via a connection wire having two third connectors at opposite ends thereof, so that the luminous elements are connected in series to form the backlight source;
a diffusion plate disposed above the backlight source; and
a housing accommodating the backlight source and the diffusion plate for constructing the lamp panel, wherein the heat dissipation area of each the luminous elements is in contact with the housing.

11. A bar-shaped luminous element, **characterized by** comprising:
a bar-shaped heat dissipation plate comprising a die bonding area and a heat dissipation area extended from one side of the die bonding area;
a body having a recess, the body encompassing the bar-shaped heat dissipation plate, the recess having a first body surface, a first recess lateral wall, and a second recess lateral wall, the first body surface exposing the die bonding area, the first recess lateral wall and the second recess lateral wall respectively extending from opposite sides of the first body surface, wherein the heat dissipation area is partially exposed on a surface of the first recess lateral wall opposite to the second recess lateral wall, wherein an angle between the first recess lateral wall and a normal line of the first body surface is *ϕ* degrees, wherein an angle between the second recess lateral wall and the normal line of the first body surface is *ϕ* degrees, wherein 0 degrees ≦ *ϕ* < 90 degrees;
a plurality of LED chips mounted on the die bonding area;
a first and a second connectors respectively disposed on opposite ends of the body, and the first and the second connectors both comprise a first and a second electrical input ports for being pluggably connected to an external power source or other connectors; and
a first and a second circuits disposed in the body, wherein the first and the second circuits are insulated from the bar-shaped heat dissipation plate, wherein the LED chips are electrically connected between the first and the second circuits, and the first circuit is electrically connected to the first electrical input ports of the first and the second connectors, and the second circuit is electrically connected to the second electrical input ports of the first and the second connectors.

12. The bar-shaped luminous element of claim 11, **characterized by** further comprising a wavelength converting unit for converting some first lights emitted by the LED chips to second lights with longer wavelength, wherein the second lights are blended with the rest first lights which are not converted, so as to form a light in white or other colors.

13. The bar-shaped luminous element of claim 12, **characterized in that** the wavelength converting unit is an encapsulating glue doped with wavelength converting material, and the encapsulating glue covers the LED chips.

14. The bar-shaped luminous element of claim 12, **characterized in that** the wavelength converting unit is positioned on the optical paths of the first lights emitted by the LED chips, and is spaced apart from the LED chips.

15. The bar-shaped luminous element of claim 14, **characterized in that** the first body surface comprises a plurality of securing holes, and the wavelength converting unit is an optical lens having wavelength converting material, and the optical lens comprises a plurality of securing legs, and the optical lens is secured above the LED chips by inserting the securing legs in the securing holes.

16. The bar-shaped luminous element of claim 15, **characterized in that** the optical lens comprises quantum dot material therein, and the interior of the optical lens is vacuum or filled with noble gas.

17. The bar-shaped luminous element of claim 11, wherein 25 degrees ≦ *ϕ* ≦ 65 degrees.

18. The bar-shaped luminous element of claim 11, **characterized in that** each of the LED chips is a cuboid, and the length of each of the LED chips is a, and the width of each of the LED chips is b, wherein the ratio R of the length a to the width b satisfies: 1≦R≦5.

19. The bar-shaped luminous element of claim 18, **characterized in that** the ratio R satisfies: 3≦R≦4.

20. The bar-shaped luminous element of claim 11, **characterized in that** each of the LED chips is apart from the boundary between the first recess lateral wall and/or the second recess lateral wall and the die bonding area at a distance D, wherein the distance D satisfies: 1 *µ*m≦D≦1000*µ*m.

21. An edge-lit type backlight module, **characterized by** comprising:
a light guide plate having a light outgoing surface and a light incident surface perpendicular to the light outgoing surface;
a bar-shaped light source comprising at least one bar-shaped luminous element of claim 11, wherein the light guide plate is inserted into the recess, and the LED chips emit lights toward the light incident surface; and
a housing accommodating the bar-shaped light source and the light guide plate for constructing the edge-lit type backlight module, wherein the heat dissipation area of the heat dissipation plate is in contact with the housing.

22. The edge-lit type backlight module of claim 21, **characterized in that** the bar-shaped light source is assembled by a plurality of the bar-shaped luminous elements of claim 11, wherein the first connector and the second connector of each of the bar-shaped luminous elements are pluggably connected to the first connector or the second connector of an adjacent one of the bar-shaped luminous elements, so that the bar-shaped luminous elements are connected in series.
